**Europäisches Patentamt**

**European Patent Office**

**Office européen des brevets**

(19)

(11) Veröffentlichungsnummer : **0 290 629 B1**

(12) **EUROPÄISCHE PATENTSCHRIFT**

(45) Veröffentlichungstag der Patentschrift :
**22.01.92 Patentblatt 92/04**

(51) Int. Cl.⁵ : **C30B 15/34**

(21) Anmeldenummer : **88900261.4**

(22) Anmeldetag : **23.10.87**

(86) Internationale Anmeldenummer :
**PCT/SU87/00118**

(87) Internationale Veröffentlichungsnummer :
**WO 88/03968 02.06.88 Gazette 88/12**

(54) **ANORDNUNG ZUR ZÜCHTUNG PROFILIERTER MONOKRISTALLE.**

(30) Priorität : **26.11.86 SU 4149059**

(43) Veröffentlichungstag der Anmeldung :
**17.11.88 Patentblatt 88/46**

(45) Bekanntmachung des Hinweises auf die
Patenterteilung :
**22.01.92 Patentblatt 92/04**

(84) Benannte Vertragsstaaten :
**AT CH DE FR GB IT LI SE**

(56) Entgegenhaltungen :
**DE-C- 2 325 104**
**US-A- 3 342 559**
**US-A- 3 915 656**
**US-A- 4 416 723**
**IBM TECHNICAL DISCLOSURE BULLETIN,**
**Band 17, Nr. 2, Juli 1974, Seite 426, New York,**
**US; T.F. CISZEK: "Crystal growth after he-**
**ater"**
**P.I. Antonov et al. " Poluchenie profilirovan-**
**nykh monokristallov i izdely sposobom Stepa-**
**nova ", 1981, Nauka, Leningrad, see page 139**

(73) Patentinhaber : **VSESOJUZNY**
**NAUCHNO-ISSLEDOVATELSKY**
**PROEKTNO-KONSTRUKTORSKY I**
**TEKHNOLOGICHESKY INSTITUT**
**ELEKTROTERMICHESKOGO**
**OBORUDOVANIA**
**VNIIETO, ul. Nizhegorodskaya, 29**
**Moscow 109052 (SU)**

(72) Erfinder : **KRAVETSKY, Dmitry Yakovlevich**
**ul. Bibliotechnaya, 13-91**
**Moscow, 109544 (SU)**
Erfinder : **ZATULOVSKY, Lev Markovich**
**Orlikov per., 8-55**
**Moscow, 107078 (SU)**
Erfinder : **EGOROV, Leonid Petrovich**
**ul. Profsojuznaya, 75-1-92**
**Moscow, 117342 (SU)**
Erfinder : **PELTS, Boris Bentsionovich**
**ul. Lesnaya, 63/43-157**
**Moscow, 103066 (SU)**
Erfinder : **OKUN, Leonid Samuilovich**
**ul. Udaltsova, 4-306**
**Moscow, 117415 (SU)**
Erfinder : **AVERIANOV, Viktor Vasilievich**
**ul. Energeticheskaya, 10-2-95**
**Moscow, 111116 (SU)**
Erfinder : **FREIMAN, Efim Alexandrovich**
**ul. 2-aya Vladimirskaya, 15-1-53**
**Moscow, 111401 (SU)**
Erfinder : **ALISHOEV, Alexandr Lvovich**
**Kronshtadtsky bulvar, 13-2-168**
**Moscow, 125493 (SU)**

(74) Vertreter : **Finck, Dieter et al**
**Patentanwälte v. Füner, Ebbinghaus, Finck**
**Mariahilfplatz 2 & 3**
**W-8000 München 90 (DE)**

EP 0 290 629 B1

## Beschreibung

Technisches Gebiet

Die vorliegende Erfindung bezieht sich auf das Gebiet der Züchtung von Kristallen aus den Schmelzen und betrifft Vorrichtungen zur Züchtung von Einkristallen der schwerschmelzbaren, optisch durchsichtigen Metallverbindungen, insbesondere Vorrichtungen zur Züchtung von profilierten Einkristallen.

Vorangehender Stand der Technik

An die Qualität der profilierten Einkristalle werden sehr hohe Anforderungen gestellt. Als Hauptmerkmale der Qualität treten die Genauigkeit der geometrischen Abmessungen, der Widerstand elektrische Durchschlagwiderstand, die Größe der integralen Lichtdurchlässigkeit, die kristallografische Entorientierung der Einkristalleinheiten und die mechanische Festigkeit hervor. Für den Leukosaphir-Einkristall der Röhrengestalt zum Beispiel sind die Abweichung von der vorgeschriebenen Durchmessergröße nur im Bereich $\pm 0,2$ mm, der elektrische Durchschlagswiderstand 50 kV/mm und die Größe der integralen Lichtdurchlässigkeit über 92% zulässig.

Die die Qualität der Einkristalle beeinflussende Ursache stellt die Art des Temperaturfeldes im System "Schmelze-Einkristall" dar, die mit der Form und der gegenseitigen Stellungslage der Wärmeschutzschilder zusammenhängt, durch welche die wärmeschützende Abschirmung des Einkristalls zustandekommt.

Zur Zeit ist bekannt eine Vorrichtung zur Züchtung der profilierten Einkristalle von schwerschmelzbaren, optisch durchsichtigen Metallverbindungen (P.I.Antonov und andere "Poluchenie profilirovannykh monokristallov i izdely sposobom Stepanova", 1981, Verlag Nauka, Leningrad, SS. 137-142), die eine luftdichte Kammer vorsieht, in welcher ein Wärmeisolationsblock mit dem die Form eines Bechers aufweisenden Heizkörper untergebracht ist, in dessen Innerem ein unter Ermöglichung von dessen Hin- und Herbewegung längs der Becherachse montierter Tiegel, ein Formengeber als Zylinder mit durchgehenden Kapillarbohrungen zur Zufuhr der Schmelze aus dem erwähnten Tiegel in die Kristallisationszone des Einkristalls, die über dem oberen Stirnende des die Querschnittsform des zu züchtenden Einkristalls besitzenden und unter dem oberen Ende des Heizkörpers liegenden Formengebers befindlich ist, und flache, waagerechtliegende Wärmeschutzschilder mit den koaxial verlaufenden Öffnungen zum Durchgang des zu züchtenden Einkristalls untergebracht sind.

Die erwähnten Wärmeschutzschilder sind zur Entwicklung eines erforderlichen Temperaturgradienten über die Länge des Einkristalls sowohl während dessen Züchtung als auch bei dessen Abkühlung vorgesehen. Darüber hinaus tragen die betreffenden Wärmeschutzschilder dem Ausgleichen der Temperatur in der Kristallisationszone des Einkristalls bei.

Die genannten flachen Wärmeschutzschilder sind aus einem schwerschmelzbaren Werkstoff in Form von Ringen mit der Stärke von je 0,5 bis 1,0 mm hergestellt und zu einem Paket aus 10 bis 20 Schildern bestehend zusammengestellt. Der Zwischenabstand zwischen den benachbarten Wärmeschutzschildern übertrifft mindestens um das 5fache von deren Stärke. Etwa die Hälfte der Wärmeschutzschilder ist im Inneren des Heizkörpers untergebracht, während die andere Hälfte über den Heizkörper herausragt. Dabei übertrifft die Zwischenabstandsgröße zwischen den Schildern und dem Heizkörper und zwischen den Wärmeschutzschildern und dem Einkristall selbst keinesfalls die doppelte Stärke der Wärmeschutzschilder. Mit Hilfe der erwähnten Wärmeschutzschilder ist in der Vorrichtung zur Züchtung von profilierten Einkristallen ein Temperaturgradient von 20 bis 30°C/cm erreicht.

Durch den erwähnten Temperaturgradienten über die Länge des gezüchteten Einkristallteils wird jedoch die Stabilität der Züchtung beeinträchtigt , d.h. selbst bei geringeren Temperaturveränderungen in der Kristallisationszone tritt eine Abweichung der Höhe des Schmelzenstabes von deren vorgeschriebener Grösse auf, was letzten Endes zur Veränderung der geometrischen Abmessungen des Querschnitts des zu züchtenden Einkristalls führt und dadurch den Ertrag der brauchbaren Kristalle erniedrigt.

Es muß betont werden, daß infolge der jeweiligen Ungenauigkeiten beim Zusammenbau und bei der Aufstellung des Pakets der Wärmeschutzschilder keine Möglichkeit in der Praxis besteht, vermittels der erwähnten Wärmeschutzschilder eine sowohl in der Kristallisationszone des Einkristalls als auch unmittelbar an dem oberen Stirnende des Formengebers konstantbleibende Temperatur zu erhalten, bevor jeweils ein verfahrenstechnischer Zyklus der Züchtung der Einkristalle angelassen wird.

Darüber hinaus werden die der Oberfläche des Heizkörpers naheliegenden Ränder der flachen Wärmeschutzschilder übererwärmt. In diesem Zusammenhang tritt eine Verkrümmung der Wärmeschutzschilder auf sowie werden auch unerwünschte physikalisch-chemische Zusammenwirkungen zwischen dem Metall, insbesondere dem Molybdän, aus welchem die Bauelemente der Vorrichtung hergestellt sind, und dem an der Oberfläche des Heizkörpers verdampfenden Kohlenstoff sowie den Beimengungen begünstigt werden, die jeweils im Inertgas enthalten sind, in dessen Umgebung der verfahrenstechnische Vorgang der Züchtung des Einkristalls verläuft. Die bei der erwähnten Zusammenwirkung entstehenden gasförmigen Produkte gelangen in die Schmelze und auch in den Einkristall hinein, sodaß dessen optische Eigenschaften verschlechtert werden.

## Offenbarung der Erfindung

Der Erfindung liegt die Aufgabe zugrunde, eine Vorrichtung zur Züchtung von profilierten Einkristallen aus den schwerschmelzbaren, optisch durchsichtigen Metallverbindungen mit einer solchen Abschirmung zu entwickeln, durch welche dank dem Ausgleichen der Temperatur am oberen Stirnende des Formengebers eine bessere Genauigkeit der geometrischen Abmessungen der zu züchtenden Einkristalle und dadurch auch einen größeren Ertrag der brauchbaren Einkristalle zu erreichen ist.

Die gestellte Aufgabe wird dadurch gelöst, daß die Vorrichtung zur Züchtung von profilierten Einkristallen der schwerschmelzbaren, optisch durchsichtigen Metallverbindungen, die eine luftdichte Kammer vorsieht in deren Innerem ein Wärmeisolationsblock mit dem die Form eines Bechers aufweisenden Heizkörper untergebracht ist, der in seinem Inneren einen unter Ermöglichung von dessen Hin- und Herverstellung längs der Bechersachse angeordneten Tiegel, einen Formengeber als Zylinder mit durchgehenden Kapillarbohrungen zur Zufuhr der Schmelze während des Betriebs der vorrichtung aus dem erwähnten Tiegel in die Kristallisationszone des zu züchtenden Einkristalls, die über dem oberen Stirnende des Formengebers liegt, welcher die Querschnittsform des zu züchtenden Einkristalls besitzt und unter dem oberen Rand des Heizkörpers zurückgehalten ist, und flache, waagerechtliegende Wärmeschutzschilder mit den koaxial angeordneten Öffnungen zum Durchgang des zu ziehenden Einkristalls trägt, dadurch gekennzeichnet, daß sie einen Wärmeschutzschild in Form eines hohlen Zylinders enthält, der innerhalb der in den flachen Wärmeschutzschildern ausgesparten Öffnungen mit ihnen koaxial aufgestellt ist.

Zweckmäßigerweise soll die Höhe des erwähnten Hohlzylinders 1,0 bis 1,6 des Abstandes zwischen dem oberen Stirnende des Formengebers und dem oberen Rand des Heizkörpers betragen, während dessen Stärke von 0,1 bis 0,15 und der Außendurchmesser von 1,5 bis 2,0 Durchmessergröße des am oberen Stirnende des Formengebers herum umgeschriebenen Kreises erreichen sollen.

Durch Benutzung des zusätzlichen Wärmeschutzschildes aus einem wärmeleitenden Werkstoff in Form eines Hohlzylinders wird die Temperaturverteilung am oberen Stirnende des Formengebers derart ermöglicht, daß die Größtdifferenz der temperatur unter 3°C liegt. Dabei wird der Temperaturgradient von 120 bis 160°C innerhalb des Heizkörpers über die ganze Höhe des zu züchtenden Einkristalls erreicht, während die Temperaturdifferenz in den Querschnittsflächen mit den unterschiedlichen Abständen von der Kristallisationsfront keinesfalls 3°C übertrifft, wodurch die Stabilität bei der Züchtung des Einkristalls gesteigert wird.

Mit Hilfe der erfindungsgemäßen Vorrichtung zur Züchtung von profilierten Einkristallen können die profilierten Einkristalle erhalten werden, deren Genauigkeit an den geometrischen Abmessungen in einem Bereich ± 0,05 mm liegt, während der Ertrag der brauchbaren Einkristalle um 35% bis 40% vergrößert werden kann.

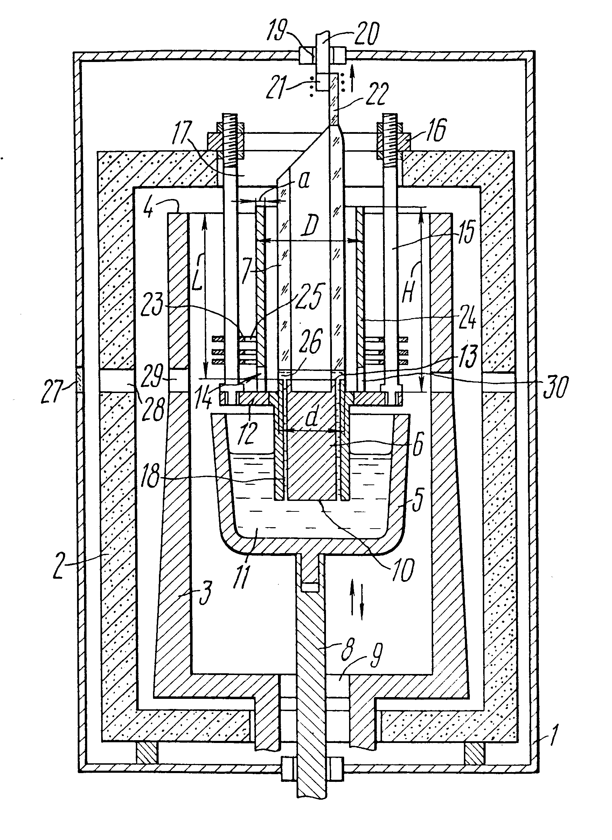

## Kurzbeschreibung der Zeichnung

Nachstehend wird die Erfindung anhand der Beschreibung eines konkreten Ausführungsbeispiels und der angelegten Zeichnung näher erläutert, in der die Gesamtansicht der Vorrichtung zur Züchtung von profilierten Einkristallen der schwerschmelzbaren optisch durchsichtigen Metallverbindungen der Erfindung gemäß in schematischer Darstellung längsgeschnitten wiedergegeben ist.

## Ausfürliche Beschreibung der Erfindung

Die erfindunsgemässe Vorrichtung zur Züchtung der profilierten Einkristalle der schwerschmelzbaren, optisch durchsichtigen Metallverbindungen wird anhand des Beispiels der Ausführung der Vorrichtung in Form eines Rohrs beschrieben. Die Vorrichtung enthält eine luftdichte Kammer 1, in deren Innerem ein Wärmeisolationsblock 2 untergebracht ist, der aus Graphit und aus einem graphitierten Tuch hergestellt ist. Innerhalb des erwähnten Wärmeisolationsblocks 2 ist ein Widerstandsheizkörper 3 eingebaut, der aus Graphit in Form eines Bechers ausgeführt ist, dessen Boden mit einer aus der Zeichnung nicht ersichtlichen Stromspeisequelle verbunden ist.

Die Stärke der Wandung des Heizkörpers 3 ändert sich in Höhenrichtung des Bechers. An dem ersten Drittel der Höhe des Heizkörpers 3 von dessen oberem Rand 4 besitzt dessen Wandung ungefähr gleiche Stärke, während am restlichen Teil des Heizkörpers 3 die Stärke dessen Wandung allmählich zunimmt, wobei die Wandungsstärke am Becherboden etwa um das 1,3fache diese am oberen Rand 4 übertrifft.

Im Inneren des Heizkörpers 3 an dessen Achse sind Tiegel 5 und Formengeber 6 untergebracht, der zur Formgebung eines Einkristalls 7 aus Leukosaphir in Form einer Röhre vorgesehen ist.

Der Tiegel 5 ist aus Molybdän hergestellt, weist eine kegelige Gestalt auf, während dessen Innenfläche poliert wird. Die Höhe des Tiegels 5 erreicht etwa 1/3 der Höhe des Heizkörpers 3. Der Tiegel 5 kann längs der Achse des Heizkörpers 3 hin- und herverstellt werden, er wird an einem Stock 8 befestigt, der durch die im Boden des Heizkörpers 3 ausgesparte Bohrung geführt wird.

In der Zeichnung ist der Tiegel 5 in der oberen Endstellung wiedergegeben, in welcher die Züchtung des Einkristalls 7 durchgeführt wird. Bei dieser Stellungslage wird der Formengeber 6 bis in den Mittelteil des Heizkörpers 3 hinuntergestellt, während dessen unteres Stirnende 10 in die Schmelze 11 der schwerschmelzbaren, optisch durchsichtigen Metallverbindung, im Beschreibungsbeispiel in die Schmelze des Aluminiumoxids hineingetaucht wird. In der unteren Endstellung, (aus der Zeichnung nicht ersichtlich) ist der Tiegel 5 in die unmittelbare Nähe des Bodens des Heizkörpers 3 gestellt. Bei dieser Stellungslage erfolgen die Beladung und Verschmelzung des Ausgangsguts der schwerschmelzbaren Metallverbindung, aus welcher der Einkristall 7 herausgezogen wird.

Der Formengeber 6 ist in einem im Mittelteil des Heizkörpers 3 angeordneten Flansch 12 eingebaut. Zur Verlängerung der Betriebsdauer des Flansches 12 soll sein Durchmesser den Durchmesser des Tiegels 5 nicht übersteigen. Das obere Ende 13 des Formengebers 6 liegt unter dem oberen Rand 4 des Heizkörpers 3 ungefähr um 1/3 Höhe des Heizkorpers 3. Über diesem oberen Stirnende 13 des Formengebers 6 liegt die Kristallisationszone 14 des Einkristalls 7. Der Flansch 12 ist an den Schraubenstangen 15 befestigt, deren Enden mit Hilfe der Gewindeverbindung an einem die im Oberteil des Wärmeisolationsblocks 2 ausgesparte Öffnung 17 teilweise überdeckenden Ring 16 fest angeschraubt sind.

Der Formengeber 6 ist aus einem mit der Schmelze der schwerschmelzbaren Metallverbindung, benetzbaren Werkstoff insbesondere aus Molybdän, hergestellt. Er dient der Zufuhr der Schmelze 11 aus dem Tiegel 5 durch das Kapillarsystem zu der Kristallisationszone 14, in der die Formgebung eines gewählten Querschnittsprofils des Einkristalls 7 stattfindet. In der Beschreibungsvariante weist der Formengeber 6 das Kapillarsystem in Form eines Ringschlitzes 18 zwecks Formgebung eines Ringquerschnitts des Einkristalls 7 auf. Der Größtdurchmesser des Einkristalls 7 ist um 0,1 bis 0,2 mm geringer als der Größtdurchmesser des oberen Stirnendes 13 des Formengebers 6, während der Kleinstdurchmesser der Einkristalls 7 um 0,05 bis 0,1 mm größer als der Kleinstdurchmesser des oberen Stirnendes 13 des Formengebers 6 ist.

Im Oberteil der luftdichten Kammer 1 ist eine Öffnung 19 vorgesehen, durch welche Stock 20 hineinragt. Am Ende des erwähnten Stocks 20 wird Keimhalter 21 mit dem einkristallinen Kristallkeim 22 befestigt.

Zur Optimierung der Temperaturverhältnisse des Ziehens des Einkristalls 7 enthält die erfindunsgemäße Vorrichtung in der Beschreibungsversion drei flache Wärmeschutzschilder 23. Diese flachen Wärmeschutzschilder 23 sind unter dem Flansch 12 waagerecht angeordnet und dienen zur Verkleinerung der Wärmeverluste in der Kristallisationszone 14. Diese Wärmeschutzschilder 23 sind aus Molybdän hergestellt und weisen die Gestalt flacher Ringe mit einer Stärke von 1 mm auf. Der Zwischenanbstand zwischen diesen Schildern beträgt 6 mm.

Darüber hinaus ist ein Wärmeschutzschild 24 vorgesehen, der zum temperaturausgleich am Umfang des Einkristalls 7 in jedem Querschnitt desselben dient. Dieser Wärmeschutzschild 24 ist als ein Hohlzylinder aus Molybdän hergestellt und an einem seiner Enden koxial zu dem zu züchtenden Einkristall 7 im Flansch 12 befestigt. Der Wärmeschutzschild 24 verläuft im Irreren der Öffnungen 25 in den flachen Wärmeschutzschildern 23, die zum Durchgang des herauszuziehenden Einkristalls 7 vorgesehen sind.

Die in der Zeichnung wiedergegebene Ausführungsversion veranschaulicht die Befestigung der flachen Wärmeschutzschilder 23 an der Außenfläche des Wärmeschutzschildes 24 vermittels nicht mitabgebildeter Stifte.

Die Höhe H des Wärmeschutzschildes 24 beträgt etwa 1,0 bis 1,6 des Abstandes L zwischen dem oberen Stirnende 13 des Formengebers 6 und dem oberen Rand 4 des Heizkörpers 3. Bei einer kleineren Höhe des Wärmeschutzschildes 24 erhöht sich der Temperaturgradient innerhalb des Einkristalls 7 und dessen Struktur wird wesentlich verschlechtert, während sich auf die Oberfläche ein Belag aus Molybdän-, Kohlenstoff-, Aluminium- und Sauerstoffverbindungen niederschlägt, wodurch der Ertrag der brauchbaren Einkristalle abnimmt. Bei einer Höhe des Wärmeschutzschildes 24 über 1,6L ändert sich die Struktur des Einkristalls 7 im wesentlichen nicht.

Der Außendurchmesser D des Wärmeschutzschildes 24 muß zwischen 1,5 und 2,0 des Durchmessers d des ums obere Stirnende 13 des Formengebers 6 umschriebenen Kreises liegen, wenn ein Einkristall 7 mit der Querschnittsform wie beispielsweise Dreieck, Sechseck, Trapez herausgezogen wird. Entsprechenderweise kann der Wärmeschutzschild 24 im einfachsten Falle die Querschnittsform eines Ringes, Dreiecks, Sechsecks bzw. eine andere Gestalt seines Querschnitts besitzen, die der Form des zu züchtenden Einkristalls 7 entspricht. Bei der Züchtung eines Einkristalls 7 in Form einer Röhre erreicht der Durchmesser d derselben die Größe des Durchmessers des oberen Stirnende 13 des Formengebers 6.

Die Stärke a des Wärmeschutzschildes 24 soll zwischen 0,1 und 0,15 des Außendurchmessers d des Einkristalls 7 gewählt werden.

Bei einem Außendurchmesser D des Wärmeschutzschildes 24 kleiner 1,5d bzw. größer 2d und seiner Stärke a kleiner 0,1d bzw. größer 0,15d kann der Ausgleich der Temperatur außerhalb des Einkristalls 7 nicht erreicht werden.

Zur visuellen Überwachung des Zustandes des Stabes 26 der Schmelze in der Kristallisationszone 14 und zur nachfolgenden Korrektur der Verhältnisse der Züchtung des Einkristalls 7 wird ein Fenster 27 in der luftdichten Kammer 1 in der Höhe des oberen Stirnendes 13 des Formengebers 6 ausgespart und sind die mit dem Fenster auf einer Achse liegenden Öffnungen 28, 29, bzw. 30 im Wärmeisolationsblock 2, Heizkörper 3 und im Wärmeschutzschild 24 an gegenüberliegenden Seiten des Einkristalls 7 vorgesehen.

Die erfindungsgemäße Vorrichtung zur Züchtung von profilierten Einkristallen der schwerschmelzbaren, optisch durchsichtigen Metallverbindungen arbeitet wie folgt.

Zunächst wird der Tiegel 5 durch Verstellung seines Stocks 8 nach oben innerhalb des Heizkörpers 3 in seine obere Endstellung hochgehoben und über die Öffnung 17 im Wärmeisolationsblock 2 wird Ausgangsgut in Form von Stücken des Aluminiumoxids beliebiger Gestalt in den Tiegel 5 hineingeschüttet. Hiernach wird der Tiegel 5 durch Herunterziehen am Stock 8 in seine untere Endstellung (aus der Zeichnung nicht ersichtlich) verschoben und innerhalb des Heizkörpers 3 der Flansch 12 mit dem Formengeber 6 und den Wärmeschutzschildern 23 und 24 zusammmegebaut montiert.

Nach dem Luftdichtmachen der kammer 1 und deren Evakuieren bis auf $6,7 \times 10^{-3}$ Pa wird das Ausglühen durchgeführt. Dazu wird eine Spannung zu dem Heizkörper 3 hingegeben und unter der Wirkung des im Heizkörper 3 entwickelten Wärmestromes werden auch der Tiegel 5 mit dem Ausgangsgut darin und der Formengeber 6 auf eine Temperatur von 1300 bis 1500°C erhitzt und bei dieser Temperatur innerhalb von 20 bis 30 Minuten zwecks Entgasung der ganzen Vorrichtung gehalten. Die Erwärmungstemperatur wird beispielsweise an einem Pyrometer überwacht. Hiernach wird die luftdichte Kammer 1 mit einem Inertgas des öfteren mit Argon, unter einem Druck von $9,81 \times 10^4$ bis $10,79 \times 10^4$ Pa ausgefüllt. Das Ausgangsgut wird im Tiegel 5 geschmolzen und jetzt kann der Tiegel 5 mit der Schmelze 11 in seine obere Endstellung zunächst bis zum Inberührungtreten des unteren Stirnendes 13 des Formengebers 6 mit der Schmelze 11 und dann weiter in seine Arbeitsstellung hochgehoben werden, in der der Abstand des oberen Stirnendes 13 des Formengebers 6 bis auf die Oberfläche der Schmelze 11 im Tiegel 5 etwa 20 mm erreicht. Die Schmelze 11 tritt im Ringschlitz 18 aus dem Tiegel 5 zu der Kristallisationszone 14 hoch.

Im Weiteren wird der Stock 20 bis zum Inberührungtreten des Kristallkeimes 22 mit dem Stirnende 13 des Formengebers 6 hinuntergeschoben, während der Kristallkeim 22 dabei abgeschmolzen wird. In diesem Zusammenhang bildet sich ein Stab 26 aus der Schmelze mit einer Höhe von 0,2 bis 0,3 mm zwischen dem Kristallkeim 22 und dem Stirnende 13 des Formengebers 6 heraus. Hiernach wird er Einkristall 7 bis auf den erforderlichen Querschnitt aufgewachsen. Diese Aufziehung erfolgt unter Verschiebung des Stockes 20 mit dem Kristallkeim 22 mit einer Verschiebunsgeschwindigkeit von 0,5 bis 1,0 mm/min.

Bei dem Aufwachsen wird der Stab 26 der Schmelze am Stirnende 13 des Formengebers 6 zu einem geschlossenen Ring umgestaltet. Hiernach wird der Einkristall 7 durch Aufwärtsverschiebung des Stockes 20 mit einer Geschwindigkeit von 1,0 bis 5,0 mm/min aus der Kristallisationszone 14 herausgezogen.

Bei der Abschelzung des Kristallkeimes 22, dem Aufwachsen und bei dem Herausziehen des Einkristalls 7 wird auch eine visuelle Überwachung des Zustandes des Stabes 26 aus der Schmelze in der Kristallisationszone 14 durchgeführt. Bei einer Abweichung der Form des Stabes 25 aus der Schmelze von der erforderlichen wird die Anwärmunstemperatur innerhalb des Heizkörpers 3 durch Veränderung der zugeführten Speiseleistung geändert.

Bei der Züchtung des Einkristalls 7 bewirkt der Wärmeschutzschild 24 durch die hohe Wärmeleitfähifkeit des Molybdäns, aus welchem er hergestellt ist, einen Temperaturausgleich am Umfang des Einkristalls 7 in jedem Querschnitt desselben, was sich insbesondere bemerkbar bei der Erzeugung der Einkristalle eines größeren Durchmessers bzw. bei einem gleichzeitigen Ziehen der ganzen Gruppe der Einkristalle auswirkt. Darüber hinaus erreicht der Temperaturgradient in der Kristallisationszone 14 einen Wert zwischen 120 und 160°C/cm durch Vorliegen eines genügendgroßen Zwischenabstandes zwischen dem Einkristall 7 und dem Wärmeschutzschild 24, durch welchen die Einkristalle mit den genauen Abmessungen des Querschnitts mit der Genauigkeit ± 0,05 mm über die ganze Länge erhalten werden.

Nach dem Erzielen einer gewählten Länge des Einkristalls 7 wird dieser von dem Stab 26 der Schmelze beispielsweise durch Absenken des Tiegels 5 abgetrennt. Hiernach wird der Einkristall 7 auf die Temperatur zwischen 1550°C und 1600°C mit der Abkühlungsgeschwindigkeit von 20° bis 30°C/min vermittels einer Verminderung der Speiseleistung des Heizkörpers 3 abgekühlt.

Beim Erreichen einer Temperatur zwischen 1550°C und 1600°C wird der Heizkörper 3 abgeschlossen und eine weitere Abkühlung des Einkristalls 7 bis auf die Umgebungstemperatur (20°C) verläuft auf natürlichem Wege.

Industrielle Anwendbarkeit

Die erfindungsgemäße Vorrichtung zur Züchtung von profilierten Einkristallen wird zur Gewinnung der Einkristalle aus verschiedenen schwerschmelzbaren, optischdurchsichtigen Metallverbindungen wie Leukosaphir, Rubin, Skandiumoxid, Yttriumtongranat ausgenutzt, die eine Schmelztemperatur von etwa 2000°C besitzen, praktisch keiner mechanischen Bearbeitung bedürfen, die im Gerätebau, in der Chemie, im Hüttenwesen und anderen Industriezweigen als Bauelemente der chemischen Apparatur, lichttechnischen und optischen Geräte, der Ausstattung von Erdölbohrungen, von Behältern zur Synthese und Analyse der besonders reinen Legierungen sowie als Werkstücke bei Herstellung der Juwelenartikel ihre breite Anwendung finden.

**Patentansprüche**

1. Vorrichtung zur Züchtung von profilierten Einkristallen aus schwerschmelzbaren, optisch durchsichtigen Metallverbindungen, die eine luftdichte Kammer (1) vorsieht, in deren Innerem ein Wärmeisolationsblock (2) mit dem die Form eines Bechers aufweisenden Heizkörper (3) untergebracht ist, der in seinem Inneren einen unter Ermöglichung von dessen Hin- und Herverstellung längs der Bechersachse angeordneten Tiegel (5), einen Formengeber (6) als Zylinder mit durchgehenden Kapillarbohrungen zur Zufuhr der Schmelze (11) während des Betriebs der Vorrichtung aus dem erwähnten Tiegel (5) in die Kristallisationszone (14) des zu züchtenden Einkristalls (7) gestaltet, welche Kristallisationszone über dem oberen Stirnende (13) des Formengebers (6) liegt, welcher die Querschnittsform des zu züchtenden Einkristalls (7) besitzt und unter dem oberen Rand (4) des Heizkörpers (3) zurückgehalten ist, und flache, waagerechtliegende Wärmeschutzschilder (23) mit den koaxial angeordneten Öffnungen (25) zum Durchgang des zu ziehenden Einkristalls (7) trägt, dadurch **gekennzeichnet**, daß sie einen Wärmeschutzschild (24) in Form eines hohlen Zylinders enthält, der innerhalb der in den flachen Wärmeschutzschildern (23) ausgesparten Öffnungen (25) mit ihnen koaxial aufgestellt ist.

2. Vorrichtung zur Züchtung von profilierten Einkristallen nach Anspruch 1, dadurch **gekennzeichnet**, daß die Höhe des hohlen Zylinders eine Größe zwischen dem 1,0 bis 1,6fachen des Abstandes zwischen dem oberen Stirnende (13) des Formengebers (6) und dem oberen Rande (4) des Heizkörpers (3) erreicht, während dessen Stärke von 0,1 bis 0,15 und der Außendurchmesser dieses Zylinders von 1,5 bis 2,0fache des Durchmessers des an dem oberen Stirnende (13) des Formengebers (6) herum umschriebenen Kreises beträgt.

**Claims**

1. A device for growing shaped single crystals of high-melting-point optically transparent metallic compounds, this device providing an air-tight chamber (1) in whose interior there is housed a heat-insulation block (2) together with the heating body (3) of beaker-shape, in its interior this heating body bearing a melting pot (5) arranged so as to render possible its displacement to-and-fro along the beaker axis, a shaper (6) constructed in the form of a cylinder with through-going capillary bores for feeding the melt (11) during operation of the device from the above-mentioned melting pot (5) into the crystallizing zone (14) of the single crystal (7) to be grown — which crystallizing zone lies above the upper end-face (13) of the shaper (6) which has the cross-sectional shape of the single crystal (7) to be grown and is retained below the upper edge (4) of the heating body (3) — , and plane horizontal heat-insulation screens (23) with the coaxially arranged openings (25) for the passage of the single crystal (7) to be drawn, characterized in that the device comprises a heat-insulation shield (24) in the form of a hollow cylinder which is inserted into the openings (25) made in the plane heat-insulation shields (23), this heat-insulation shield (24) being inserted coaxial to the openings (25).

2. A device for growing shaped single crystals in accordance with Claim 1, characterized in that the height of the hollow cylinder is between 1.0 and 1.6 times the distance between the upper end-face (13) of the shaper (6) and the upper edge (4) of the heating body (3), while the thickness of the hollow cylinder is from 0.1 to 0.15 times and the outside diameter of this cylinder is from 1.5 to 2.0 times the diameter of the circle described around the upper end-face (13) of the shaper (6).

**Revendications**

1. Dispositif pour la croissance de monocristaux profilés de composés métalliques difficilement fusibles et optiquement transparents où est prévue une chambre (1) étanche à l'air, à l'intérieur de laquelle est disposé un bloc de calorifugeage (2) avec le corps de chauffe présentant la forme d'un bécher, qui porte intérieurement un creuset (5) agencé avec possibilité de son déplacement en va-et-vient le long de l'axe du bécher, un façonneur (6) en tant que cylindre avec perçage capillaire traversant pour l'alimentation du produit fondu (11) pendant le fonctionnement du dispositif, dudit creuset (5) dans la zone de cristallisation (14) permettant la croissance du monocristal, laquelle zone de cristallisation se trouve sur l'extrémité frontale supérieure (13) du façonneur (6), qui possède la forme en section transversale du monocristal (7) à faire croître et est retenue sous le bord supérieur (4) du corps de chauffe (3) et des écrans protecteurs de la chaleur plats et se trouvant horizontalement (23) avec les ouvertures coaxiales (25) pour le passage du monocristal (7) à faire croître, caractérisé en ce qu'il comporte un écran de protection contre la chaleur (24) sous la forme d'un cylindre creux qui est placé à l'intérieur des ouvertures (25) formées dans les écrans plats (23) de protection contre la chaleur coaxialement à celles-ci.

2. Dispositif pour la croissance de monocristaux profilés selon la revendication 1, caractérisé en ce que la hauteur du cylindre creux atteint une grandeur comprise entre 1,0 et 1,6 fois la distance entre l'extrémité frontale supérieure (13) du façonneur (6) et le bord supérieur (4) du corps de chauffe (3), tandis que son épaisseur est de 0,1 à 0,15 fois et le diamètre externe de ce cylindre de 1,5 à 2,0 fois le diamètre du cercle entourant le bord supérieur (13) du façonneur (6).